# EUROPÄISCHE PATENTANMELDUNG

(11) **EP 0 947 612 A2**
(43) Veröffentlichungstag der Anmeldung: **06.10.1999**
(21) Anmeldenummer: 98117571.4
(22) Anmeldetag: 16.09.1998
(51) Int. Cl.: C30B 15/30, C30B 15/00

(54) **Vorrichtung zum Halten eines Kristallblockes**

(30) Priorität: 11.12.1997 DE 19754961
(71) Anmelder: Leybold Systems GmbH, 63450 Hanau (DE)
(72) Erfinder: Scholler, Johann, 64859 Eppertshausen (DE)
(74) Vertreter: Schlagwein, Udo, Dipl.-Ing.

(57) **Zusammenfassung**

An einer Ziehwelle (1) ist eine Ziehwellenverlängerung (2) befestigt. Diese hat einen als Kugellager ausgebildeten, flanschartig nach außen ragenden Mitnehmer (13). Oberhalb des Mitnehmers (13) ist ein Tragring (6) einer Greifvorrichtung (4) angeordnet. Bewegt sich die Ziehwelle (1) nach oben, so nimmt sie die Greifvorrichtung (4) mit nach oben, sobald ihr Mitnehmer (13) gegen diesen Haltering (6) gelangt. Mittels eines Betätigungskolbens (18) ist es möglich, Greiferarme (5) der Greifvorrichtung (4) in Spannstellung zu bewegen und dadurch einen Kristallblock zu haltern.

## Beschreibung

Die Erfindung betrifft eine Vorrichtung zum Halten eines Kristallblockes in einer Kristallziehanlage, bei der eine Kühlkanäle für ein Kühlmedium aufweisende, in Vertikalrichtung verfahrbare Ziehwelle mit einem Impfkristallhalter versehen ist, an welchem sich beim Ziehen des Kristallblockes ein durchmesserkleinerer Kristallhals und daran ein durchmessergrößerer Kristallblock bildet.

Beim Ziehen von Kristallblöcken tritt das Problem auf, dass die Größe des erzeugten Kristallblockes durch den sich zunächst am Impfkristallhalter ausbildenden, durchmesserkleineren Kristallhals begrenzt ist. Werden die Kristallblöcke zu groß und damit zu schwer, ist der Kristallhals nicht mehr in der Lage, diesen zu halten, so dass es zu einem Bruch des Kristallhalses kommt. Man könnte zur Behebung dieses Nachteils daran denken, den entstehenden Kristallblock zusätzlich durch eine außenseitig an ihm angreifende Tragvorrichtung abzustützen, was jedoch technisch schwierig ist, da die Tragvorrichtung erst eingesetzt werden kann, wenn sich ein ausreichend langer Kristallhals gebildet hat, und da verhindert werden muss, dass die Tragvorrichtung quer zur Längsachse des Kristallblockes sich nicht gegenseitig aufhebende Kräfte auf diesen ausübt, wodurch es zu einem Abbrechen des Kristallhalses kommen würde.

Der Erfindung liegt das Problem zugrunde, eine Vorrichtung zum Halten eines Kristallblockes zu entwickeln, welche zunächst ein unbehindertes Ziehen des Kristallblockes ermöglicht und mit der anschließend ein Abstützen des durchmessergrößeren Kristallblockes möglich wird, ohne dass hierdurch Querkräfte in den Kristallblock eingeleitet werden.

Dieses Problem wird erfindungsgemäß dadurch gelöst, dass axial verschiebbar auf der Ziehwelle eine zumindest zwei gegen den Kristallblock anlegbare, Greiferarme aufweisende, auf eine Abstützung von oben her aufsetzbare Greifvorrichtung angeordnet ist, dass die Ziehwelle an ihrer Außenseite einen durch den Vertikalhub der Ziehwelle gegen einen Tragring der Greifvorrichtung bewegbaren Mitnehmer aufweist und dass die Ziehwelle mit einer Betätigungsvorrichtung zum Betätigen der Greiferarme versehen ist.

Eine solche Greifvorrichtung hat zunächst keinerlei Einfluss auf die Bewegung der Ziehwelle mit ihrem Impfkristallhalter beim Bilden des Kristallhalses, da sich die Ziehwelle nach dem Aufsetzen der Greifvorrichtung auf den Tiegel mit der die Kristalle bildenden Schmelze eine unbehinderte Abwärtsbewegung und sich anschließende Aufwärtsbewegung des Impfkristallhalters bei der Ziehung der Kristalle erlaubt. Erst wenn beim Ziehvorgang der Impfkristallhalter sich so weit aufwärts bewegt hat, dass mit der Bildung des durchmessergrößeren Kristallblockes begonnen werden konnte, kommt es durch den Mitnehmer zu einem Anheben der Greifvorrichtung synchron zur Ziehwelle. Eine erst dann eingeleitete Schließbewegung der Greifvorrichtung, die auf unterschiedliche Weise erfolgen kann, führt zu einem Halten des entstandenen Kristallblockes, so dass der Kristallhals nicht mehr das Gewicht des Kristallblockes oder nur noch ein Teil des Gewichtes des Kristallblockes übertragen muss. Deshalb erlaubt es die erfindungsgemäße Vorrichtung, schwere Kristallblöcke zu ziehen, ohne dass die Gefahr eines Abbrechens des Kristallhalses besteht.

Da Kristallblöcke ein relativ hohes Gewicht haben können, müssen mit der Greifvorrichtung hohe Haltekräfte erzeugt werden können. Das lässt sich am gleichförmigsten durch eine Druckmittelbeaufschlagung der Betätigungsvorrichtung erzeugen. Der hierzu erforderliche Aufwand ist besonders gering, wenn gemäß einer Weiterbildung der Erfindung die Betätigungsvorrichtung zumindest einen durch Erhöhung des Druckes des Kühlmediums verschieblichen Betätigungskolben aufweist.

Konstruktiv besonders einfach ist die erfindungsgemäße Vorrichtung gestaltet, wenn die Betätigungsvorrichtung einen einzigen, koaxial zur Ziehwelle angeordneten Betätigungskolben aufweist, der an seiner Mantelfläche schräg zur Längsachse der Ziehwelle verlaufende Spannrampen hat, gegen die jeweils ein radial angeordneter und verschieblicher, einen Greiferarm betätigender Spannfinger anliegt.

Bei einer solchen Betätigung über Spannrampen lässt es sich nicht vermeiden, dass infolge von Fertigungstoleranzen oder Ungleichförmigkeiten der Außenkontur des Kristallblockes ein Greiferarm früher gegen den Kristallblock gelangt als die anderen. Dadurch entsteht das Problem, dass dieser den Kristallblock zu einer Seite hin wegdrücken will und es zu einem Brechen des Kristallhalses kommen kann. Das lässt sich auf besonders einfache Weise und ohne das Erfordernis der Einhaltung enger Fertigungstoleranzen verhindern, wenn gemäß einer ganz besonders vorteilhaften Weiterbildung der Erfindung der Betätigungskolben als Hohlkolben ausgebildet ist und in einem Führungszylinder ausschließlich nahe seiner unteren Stirnfläche gegen den Führungszylinder allseitig kippbar anliegt und mit seinem oberen Ende über einen Faltenbalg dichtend mit dem Führungszylinder verbunden ist. Ein solcher Betätigungskolben führt in seinem Führungszylinder eine Kippbewegung aus, wenn nur ein Greiferarm gegen den Kristallblock anliegt. Diese Kippbewegung endet erst dann, wenn alle Greiferarme gleichmäßig gegen den Kristallblock anliegen, so dass erst danach durch einen weiteren Hub des Betätigungskolbens die Spannkräfte erzeugt werden und diese deshalb zwangsläufig gleichmäßig sind.

Sowohl das zur Erzeugung gleichförmiger Haltekräfte notwendige Kippen als auch eine reibungsarme Hubbewegung des Betätigungskolbens können mit geringem konstruktiven Aufwand erreicht werden, wenn der Betätigungskolben nahe seiner unteren Stirnfläche mit mehreren, in Ausnehmungen seiner Mantelfläche eingesetzten Kugeln gegen den Führungszylinder anliegt.

Solange die Greifvorrichtung auf einer Abstützung oberhalb des Tiegels mit der Schmelze aufsitzt, wird sie von der Ziehwelle nicht rotierend angetrieben. Die Übertragung der Drehbewegung beim Abheben von der Abstützung erfolgt ruckfrei, wenn als Mitnehmer auf der Ziehwelle ein von unten her gegen den Tragring bewegliches Kugellager angeordnet ist.

Zur weiteren Vereinfachung des konstruktiven Aufbaus der Vorrichtung trägt es bei, wenn von dem Tragring der Greifvorrichtung Stützarme zu einem tiefer angeordneten Haltering führen und dieser Haltering Gelenkachsen für jeweils einen Greiferarm aufweist, welcher am unteren Ende seines unteren Hebelarmes ein Druckstück zur Anlage gegen den Kristallblock hat und mit seinem oberen Hebelarm gegen jeweils einen der Spannfinger anliegt.

Ziehvorrichtungen können je nach Bedarf mit der erfindungsgemäßen Greifvorrichtung versehen werden oder für kleinere Kristallblöcke auch ohne eine solche Greifvorrichtung arbeiten, wenn der Führungszylinder mit dem Betätigungskolben, die Greifvorrichtung und ihre Betätigungsvorrichtung eine Baueinheit mit einer zur Befestigung an der Ziehwelle ausgebildeten Ziehwellenverlängerung eine Baueinheit bilden.

Die Kühlung der Vorrichtung kann auf besonders einfache Weise dadurch verwirklicht werden, dass der Führungszylinder an seiner Unterseite durch eine Stirnwand verschlossen ist, dass zur Bildung eines Kühlmittelraumes mit Abstand zu dieser Stirnwand der Impfkristallhalter in den Führungszylinder eingesetzt ist und dass dieser Kühlmittelraum über Kühlkanäle Verbindung mit einer Kühlmittelversorgung hat.

Auch die dem Kristallblock zugewandte untere Stirnseite der Vorrichtung und der Impfkristallhalter selbst sind gut gekühlt, wenn die Ziehwelle ein zentrales Kühlrohr zur Zufuhr des Kühlmediums aufweist, welches in den Betätigungskolben bis nahe seiner unteren Stirnfläche greift, und wenn vom oberen Ende des Führungszylinders die Kühlkanäle zu dem Kühlmittelraum und von dort weitere Kühlkanäle zu einem das Kühlrohr umgebenden Rückführkanal führen.

Weil beim Ziehen eines Kristallblockes sich die Ziehwelle dreht, die Greifvorrichtung jedoch zunächst stillsteht, kommt es vor dem Abheben der Greifvorrichtung von ihrer Abstützung zu einer Relativbewegung zwischen den Spannfingern und den Greiferarmen. Man muss deshalb dafür sorgen, dass bei Beendigung der Relativbewegung die Spannfinger tatsächlich die Greiferarme zu betätigen vermögen. Das kann auf unterschiedliche Weise erreicht werden. Die Ziehwelle und die Greifvorrichtung brauchen bei synchronem Lauf keine exakte Winkelposition zueinander zu haben, wenn die Greiferarme in Höhe der Spannfinger nach beiden Seiten hin bogenförmig mit Abstand zur Ziehwellenverlängerung verlaufende Stege aufweisen.

Die Erfindung lässt zahlreiche Ausführungsformen zu. Zur weiteren Verdeutlichung ihres Grundprinzips ist eine davon in der Zeichnung dargestellt und wird nachfolgend beschrieben. Diese zeigt in
- Fig.1: einen senkrechten Schnitt durch einen für die Erfindung wesentlichen Bereich einer Kristallziehanlage,
- Fig.2: einen gegenüber Figur 1 im Maßstab vergrößerten Teilbereich der Vorrichtung nach der Figur 1.

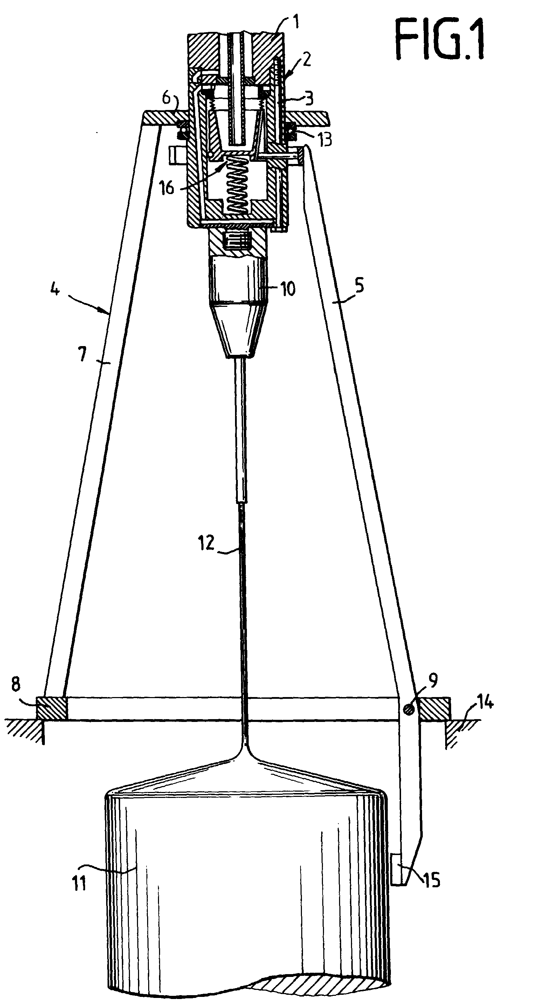

Die Figur 1 zeigt ein unteres Ende einer Ziehwelle 1, an welcher eine Ziehwellenverlängerung 2 mit Schrauben 3 befestigt ist. Diese Ziehwellenverlängerung 2 haltert eine Greifvorrichtung 4, welche drei Greiferarme 5 aufweist. Die Greifvorrichtung 4 hat an ihrer Oberseite einen Tragring 6, durch den hindurch die Ziehwelle 1 mit Spiel greift, so dass sie von der Greifvorrichtung 4 unbehindert in Vertikalrichtung beweglich ist. Vom Tragring 6 führen vorzugsweise drei Stützarme 7 zu einem unteren Haltering 8. Dieser Haltering 8 hat Gelenkachsen 9, welche jeweils einen der Greiferarme 5 lagern.

Die Ziehwellenverlängerung 2 trägt an ihrer unteren Stirnseite einen Impfkristallhalter 10, an welchem ein Kristallblock 11 mit einem Kristallhals 12 hängt. Die Ziehwellenverlängerung 2 hat unterhalb des Tragringes 6 einen als Kugellager ausgebildeten Mitnehmer 13. In der dargestellten Position stützt sich die Greifvorrichtung 4 mit ihrem Haltering 8 auf einer ortsfesten Abstützung 14 ab. Die Ziehwelle 1 konnte sich bis zum Erreichen der in Figur 1 gezeigten Position frei nach oben bewegen. Sobald jedoch der Mitnehmer 13 von unten her gegen den Tragring 6 anliegt, wird die Greifvorrichtung 4 mit der Ziehwelle 1 synchron angehoben und in eine mit der Ziehwelle 1 synchrone Drehbewegung versetzt. Um zu erreichen, dass das volle Gewicht des Kristallblockes 11 über den Kristallhals 12 getragen werden muss, lassen sich die Greiferarme 5 mittels einer Betätigungsvorrichtung 16 derart um die Gelenkachsen 9 verschwenken, dass sich Druckstücke 15 am jeweiligen unteren Hebelarm der Greiferarme 5 gegen den Kristallblock 11 legen und ihn dadurch halten.

Hat man einen fertig gezogenen Kristallblock der Vorrichtung entnommen, nachdem der Druck des Kühlmediums verringert wurde und dadurch die Greiferarme 5 öffneten, dann fährt man mit der Ziehwelle 1 abwärts. Sobald sich die Greifvorrichtung 4 mit ihrem Haltering 8 wieder auf die Abstützung 14 abstützt, wird ihre Drehbewegung beendet.

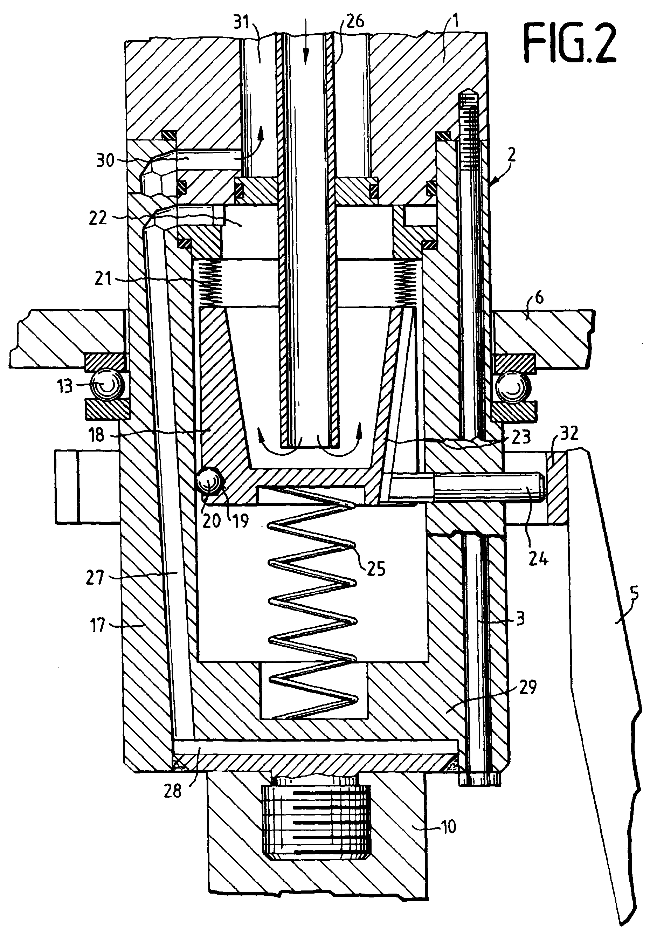

Die für die Erfindung wesentliche Gestaltung der Ziehwellenverlängerung 2 ergibt sich insbesondere aus der Figur 2. Dort ist zu sehen, dass die Ziehwellenverlängerung 2 einen an ihrem unteren Ende geschlossenen Führungszylinder 17 hat, in welchem ein nach oben hin offener, topfförmiger Betätigungskolben 18 angeordnet ist. Dieser Betätigungskolben 18 hat nahe seiner unteren Stirnfläche in seiner Mantelfläche in einer gemeinsamen Höhe beispielsweise vier Ausnehmungen 19, aus welchen jeweils eine gegen die Innenmantelfläche des Führungszylinders 17 anliegende Kugel 20 ragt. Hierdurch wird der Betätigungskolben 18 nur nahe seines unteren Endes im Führungszylinder 17 geführt. Da er im übrigen beträchtliches Spiel hat, kann er mit seinem oberen Ende allseitig im Führungszylinder 17 kippen.

Das obere Ende des Betätigungskolbens 18 ist über einen Faltenbalg 21 und einem Ring 22 dichtend mit dem Führungszylinder 17 verbunden. In seiner Außenmantelfläche hat der Betätigungskolben 18 drei Spannrampen 23, welche nach oben hin zunehmenden Abstand von der Mittelachse der Vorrichtung aufweisen. Gegen jeweils eine Spannrampe 23 liegt ein Spannfinger 24 an, der sich mit seinem anderen Ende am Greiferarm 5 abstützt. Eine Druckfeder 25 spannt den Betätigungskolben 18 in der dargestellten Position vor.

Der Figur 2 ist weiterhin zu entnehmen dass die Greiferarme 5 in Höhe der Spannfinger 24 nach beiden Seiten hin bogenförmig mit Abstand zur Ziehwellenverlängerung 2 verlaufende Stege 32 aufweisen. Hierdurch wird erreicht, dass zur Betätigung der Greiferarme 5 die Spannfinger 24 nicht exakt mit den Greiferarmen 5 fluchten müssen. Bei einem Winkelversatz gelangen sie vielmehr gegen einen der Stege 32 und vermögen dadurch ebenfalls den jeweiligen Greiferarm 5 zu betätigen.

Zur Kühlung der gesamten Anordnung führt ein Kühlrohr 26 koaxial durch die Ziehwelle 1 hindurch und endet kurz vor der unteren Stirnfläche des Betätigungskolbens 18. Das durch dieses Kühlrohr 26 zugeführte Kühlmedium, üblicherweise Wasser, strömt vom Inneren des Betätigungskolbens 18 nach oben und von dort über Kühlkanäle 27 in der Wandung des Führungszylinders 17 nach unten in einen Kühlmittelraum 28, welcher zwischen einer unteren Stirnwand 29 des Führungszylinders 17 und der Oberseite des Impfkristallhalters 10 gebildet ist. Von diesem Kühlmittelraum 28 steigt das Kühlmedium durch weitere Kühlkanäle 30 in einen Rückführkanal 31, welcher das Kühlrohr 26 umgibt.

### Bezugszeichenliste

- 1: Ziehwelle
- 2: Ziehwellenverlängerung
- 3: Schraube
- 4: Greifvorrichtung
- 5: Greiferarm
- 6: Tragring
- 7: Stützarme
- 8: Haltering
- 9: Gelenkachse
- 10: Impfkristallhalter
- 11: Kristallblock
- 12: Kristallhals
- 13: Mitnehmer
- 14: Abstützung
- 15: Druckstück
- 16: Betätigungsvorrichtung
- 17: Führungszylinder
- 18: Betätigungskolben
- 19: Ausnehmung
- 20: Kugel
- 21: Faltenbalg
- 22: Ring
- 23: Spannrampe
- 24: Spannfinger
- 25: Druckfeder
- 26: Kühlrohr
- 27: Kühlkanal
- 28: Kühlmittelraum
- 29: Stirnwand
- 30: Kühlkanal
- 31: Rückführkanal
- 32: Steg

## Patentansprüche

1. Vorrichtung zum Halten eines Kristallblockes in einer Kristallziehanlage, bei der eine Kühlkanäle für ein Kühlmedium aufweisende, in Vertikalrichtung verfahrbare Ziehwelle mit einem Impfkristallhalter versehen ist, an welchem sich beim Ziehen des Kristallblockes ein durchmesserkleinerer Kristallhals und daran ein durchmessergrößerer Kristallblock bildet, **dadurch gekennzeichnet**, dass axial verschiebbar auf der Ziehwelle (1) eine zumindest zwei gegen den Kristallblock (11) anlegbare Greiferarme (5) aufweisende, auf eine Abstützung von oben her aufsetzbare Greifvorrichtung (4) angeordnet ist, dass die Ziehwelle (1) an ihrer Außenseite einen durch den Vertikalhub der Ziehwelle (1) gegen einen Tragring (6) der Greifvorrichtung (4) bewegbaren Mitnehmer (13) aufweist und dass die Ziehwelle (1) mit einer Betätigungsvorrichtung (16) zum Betätigen der Greiferarme (5) versehen ist.

2. Vorrichtung nach Anspruch 1, **dadurch gekennzeichnet**, dass die Betätigungsvorrichtung (16) zumindest einen durch Erhöhung des Druckes des Kühlmediums verschieblichen Betätigungskolben (18) aufweist.

3. Vorrichtung nach Anspruch 2, **dadurch gekennzeichnet**, dass die Betätigungsvorrichtung (16) einen einzigen, koaxial zur Ziehwelle (1) angeordneten Betätigungskolben (18) aufweist, der an seiner Mantelfläche schräg zur Längsachse der Ziehwelle (1) verlaufende Spannrampen (23) hat, gegen die jeweils ein radial angeordneter und verschieblicher, einen Greiferarm (5) betätigender Spannfinger (24) anliegt.

4. Vorrichtung nach Anspruch 3, **dadurch gekennzeichnet**, dass der Betätigungskolben (18) als Hohlkolben ausgebildet ist und in einem Führungszylinder (17) ausschließlich nahe seiner unteren Stirnfläche gegen den Führungszylinder (17) allseitig kippbar anliegt und mit seinem oberen Ende über einen Faltenbalg (21) dichtend mit dem Führungszylinder (17) verbunden ist.

5. Vorrichtung nach Anspruch 3, **dadurch gekennzeichnet**, dass der Betätigungskolben (18) nahe seiner unteren Stirnfläche mit mehreren, in Ausnehmungen (19) seiner Mantelfläche eingesetzten Kugeln (20) gegen den Führungszylinder (17) anliegt.

6. Vorrichtung nach zumindest einem der vorangehenden Ansprüche, **dadurch gekennzeichnet**, dass als Mitnehmer (13) auf der Ziehwelle (1) ein von unten her gegen den Tragring (6) bewegliches Kugellager angeordnet ist.

7. Vorrichtung nach zumindest einem der vorangehenden Ansprüche, **dadurch gekennzeichnet**, dass von dem Tragring (6) der Greifvorrichtung (4) Stützarme zu einem tiefer angeordneten Haltering (8) führen und dieser Haltering (8) Gelenkachsen (9) für jeweils einen Greiferarm (5) aufweist, welcher am unteren Ende seines unteren Hebelarmes ein Druckstück (15) zur Anlage gegen den Kristallblock (11) hat und mit seinem oberen Hebelarm gegen jeweils einen der Spannfinger (24) anliegt.

8. Vorrichtung nach zumindest einem der vorangehenden Ansprüche, **dadurch gekennzeichnet**, dass der Führungszylinder (17) mit dem Betätigungskolben (18), die Greifvorrichtung (4) und ihre Betätigungsvorrichtung (16) eine Baueinheit mit einer zur Befestigung an der Ziehwelle (1) ausgebildeten Ziehwellenverlängerung (2) eine Baueinheit bilden.

9. Vorrichtung nach zumindest einem der vorangehenden Ansprüche, **dadurch gekennzeichnet**, dass der Führungszylinder (17) an seiner Unterseite durch eine Stirnwand (29) verschlossen ist, dass zur Bildung eines Kühlmittelraumes (28) mit Abstand zu dieser Stirnwand (29) der Impfkristallhalter (10) in den Führungszylinder (17) eingesetzt ist und dass dieser Kühlmittelraum (28) über Kühlkanäle (27) Verbindung mit einer Kühlmittelversorgung (Kühlrohr 26) hat.

10. Vorrichtung nach Anspruch 9, **dadurch gekennzeichnet**, dass die Ziehwelle (1) ein zentrales Kühlrohr (26) zur Zufuhr des Kühlmediums aufweist, welches in den Betätigungskolben (18) bis nahe seiner unteren Stirnfläche greift und dass vom oberen Ende des Führungszylinders (17) die Kühlkanäle (27) zu dem Kühlmittelraum (28) und von dort weitere Kühlkanäle (30) zu einem das Kühlrohr (26) umgebenden Rückführkanal (31) führen.

11. Vorrichtung nach zumindest einem der vorangehenden Ansprüche, **dadurch gekennzeichnet**, dass die Greiferarme (5) in Höhe der Spannfinger (24) nach beiden Seiten hin bogenförmig mit Abstand zur Ziehwellenverlängerung (2) verlaufende Stege (32) aufweisen.
